# EUROPÄISCHE PATENTSCHRIFT

(11) **EP 1 516 026 B1**
(45) Veröffentlichungstag und Bekanntmachung des Hinweises auf die Patenterteilung: **28.08.2013**
(21) Anmeldenummer: 03732583.4
(22) Anmeldetag: 20.06.2003
(51) Int. Cl.: C09D 201/10, C08F 230/08, C09D 143/04, H01L 21/768

(54) **VERFAHREN ZUM VERSIEGELN POROSER MATERIALIEN BEI DER CHIPHERSTELLUNG UND VERBINDUNGEN HIERFUR**
METHOD FOR SEALING POROUS MATERIALS DURING CHIP PRODUCTION AND COMPOUNDS THEREFOR
PROCEDE POUR SCELLER DES MATERIAUX POREUX, LORS DE LA FABRICATION DE PUCES, ET COMPOSES PREVUS A CET EFFET

(30) Priorität: 20.06.2002 DE 10227663
(43) Veröffentlichungstag der Anmeldung: 23.03.2005
(73) Patentinhaber: Infineon Technologies AG, 85579 Neubiberg (DE)
(72) Erfinder: SCHMIDT, Michael, D-01109 Dresden (DE); TEMPEL, Georg, D-01277 Dresden (DE); HEILIGER, Ludger, 67433 Neustadt (DE)
(74) Vertreter: Isarpatent
(86) Internationale Anmeldenummer: PCT/EP2003/006527
(87) Internationale Veröffentlichungsnummer: WO 2004/000960

(56) Entgegenhaltungen:
- EP-A- 1 122 278
- WO-A-01/54190
- FR-A- 2 819 635
- US-A- 5 061 739
- US-A- 5 773 197
- PATENT ABSTRACTS OF JAPAN vol. 2000, no. 09, 13. Oktober 2000 (2000-10-13) & JP 2000 154349 A (JAPAN ENERGY CORP), 6. Juni 2000 (2000-06-06)
- DATABASE CAPLUS [Online] CHEMICAL ABSTRACTS SERVICE, COLUMBUS, OHIO, US; jp4077525, 11. März 1992 (1992-03-11) "MANUFACTURE OF MERCAPTO GROUP-TERMINATED POLYETHERS AND WEATHER-RSISTANT SEALANTS THEREFROM" retrieved from STN Database accession no. 1992:512314 XP002256549 & JP 04 077525 A (TOSHIBA SILICONE K.K.) 11. März 1992 (1992-03-11)
- PATENT ABSTRACTS OF JAPAN vol. 1998, no. 01, 30. Januar 1998 (1998-01-30) & JP 09 241532 A (DAINIPPON INK &CHEM INC), 16. September 1997 (1997-09-16)

## Beschreibung

Die vorliegende Erfindung betrifft ein Verfahren, bei dem Polymerverbindungen mit funktionellen Gruppen A und B zum Versiegeln oberflächenexponierter Poren poröser, bei der Chipherstellung eingesetzter Materialien eingesetzt werden, die Verbindungen hierfür sowie die Verwendung der Polymerverbindungen.

### Hintergrund der Erfindung und Stand der Technik

Die Integration mehrfacher Metallisierung in integrierten Schaltkreisen bzw. Chips erfordert große Veränderungen bezüglich des Materials und der technologischen Verfahren, um Verzögerungen, Kapazitäten und Kopplungen zwischen verschiedenen Metallbahnen zu verringern. Der Ersatz von Siliciumdioxid durch Dielektrika mit niedriger Dielekrizitätskonstante (scg. low-k-Materialien oder interlayer dielectrics - ILD) ist für hohe Dichten und Hochgeschwindigkeitsanwendungen zwingend erforderlich. Als Ersatz für Siliciumdioxid werden beispielsweise kohlenstoffdotiertes Siliciumdioxid, andere siliciumhaltige Materialien und kohlenstoffhaltige Verbindungen eingesetzt.

### Beispiele derzeit häufig verwendeter ILD sind:

| Produkt | Firma | Materialtyp: |
|---|---|---|
| XLK | Dow Corning | Hydrogen-Silsesquioxan (HSQ) |
| 9-2222(Boss) | Dow Corning | HSQ/MSQ (Methyl-Silsesquioxane) |
| LKD5109 | JSR | MSQ |
| Zirkon | Shipley | MSQ |
| SiLK/p-SiLK (Version 1-9) | Dow Chemical | Organische Verbindung; Si-haltig |

### Black Diamond(I/II) Applied Material enthält auch Silicium

Fast alle verwendeten low-k Materialien enthalten Siliziumverbindungen. Ausnahmen sind z.B. SiLK und p-SiLK(p = porös), welches rein organische Verbindungen sind, sowie fluorierte Kohlenwasserstoffe.

Diese Materialien werden während der Chipfertigung aufgebracht und dienen als Trennschichten zwischen Metallisierungsebenen. Diese Schichten werden auch als "interlayer dielectrics" (ILD) bzeichnet. Andere Bezeichnungen sind "intermetal dielectric" (IMD) oder "low k Schichten".

In diese ILD werden bei der Chipfertigung Vertiefungen geätzt, die wiederum mit einem metallischen Material aufgefüllt werden und damit als metallische Leiterbahnen fungieren. Zusätzlich werden die Metallbahnen auch vertikal miteinander verbunden. Dies geschieht dadurch, dass die obengenannten Vertiefungen an diesen Kontaktstellen bis zur darunterliegenden Metallbahn geätzt werden. Häufig sind zusätzliche Hilfsschichten aus Siliciumnitrid und/oder SiC etwa als Ätzstoppschicht, als Ätzmaske oder als Schutzschicht notwendig. Das beschriebene Verfahren ist Stand der Technik und wird als Dual Damascene Verfahren bezeichnet.
Speziell in den besagten low-k ILD-Materialien treten stets intrinsiche Blasen, also Hohlräume, auf, die beim Härten mittels Erhitzen der aufgebrachten ILD-Schichten entstehen.

Diese Poren können im Zuge von während der Chipfertigung üblichen sich anschließenden Verfahrensschritten, die für das ILD-material eine thermische und/oder mechanische Belastung darstellen (z.B. Ätzen, chemisch mechanisches Polieren (CMP)o.ä.) noch größere Hohlräume bilden, indem einzelne Poren durch Kanäle miteinander verbunden werden. Insbesondere an den Innenwandbereichen der in diese Materialien geätzten Vertiefungen sind oberflächenexponierte Poren und damit durch Kanäle verbundene Poren ungeschützt verunreinigenden chemischen Substanzen ausgesetzt. Im Rahmen der Chipherstellung kommen hier die Materialien mit niedriger Dielektrizitätskonstante mit verschiedenen Materialien in Kontakt, beispielsweise Wasser, Luftfeuchtigkeit oder anderen Chemikalien und diese Substanzen können in die Hohlräume eindringen und so die eigentliche Funktion der interdielektrischen Schichten (ILD) wieder verschlechtern bzw. zunichte machen.

Für die Integration poröser Materialien insbesondere im "back end of line (BEOL)" Bereich der Chipfertigung ist es von großem Interesse, das Eindringen von verunreinigenden Substanzen in das poröse Material zu verhindern. Unter "back end of line" versteht man den Bereich der Chip-Produktion, in dem die elektrischen Komponenten, also z.B. Transistoren, Kapazitäten, etc., verdrahtet werden. Hierzu werden die elektrischen Komponenten über Kontakte (via) und Metallbahnen (metal-trenches) dreidimensional miteinander verbunden. Im "front end of line" der Chip-Produktion werden dagegen die elektrischen Komponenten hergestellt.

Im Bereich der Versiegelung von oberflächenexponierten Poren in siliciumhaltigen Materialien ist bereits bekannt, Siloxanpolymere mittels Ozon zu SiO₂ umzuwandeln (M.Ouyang et al., Chem. Mater., 12 (2000) 1591).

EP 1 138 732 A2, EP 1 122 278 A2 und JP-1149879 A1 (Patent Abstracts of Japan) beschreiben Polymerverbindungen, die Si-haltige organische Bestandteile und Benzotriazolbestandteile enthalten. DE 4107664 A1 beschreibt Zusammensetzungen, die Si-haltige organische Verbindungen und als weitere Bestandteile Benzotriazol enthalten können.

Die WO 01/54190 A1 beschreibt ein Verfahren zum Füllen von Kontaktöffnungen und Vertiefungen (Gräben, Vias) mit Kupfer bei der Chipfertigung, wobei die Seitenwände von in low-k-Materialien geätzten Vertiefungen mit einer zusätzlichen dielektrischen Schicht versehen werden. Als Beispiele für dielektrische Materialien sind Oxide wie Germaniumoxid, Siliciumdioxid, stickstoffhaltiges Siliciumdioxid, stickstoffdotiertes Siliciumdioxid, Siliciumoxynitrid und Oxynitride genannt. Weiterhin sind genannt: Titaniumoxid, Tantaloxid, Bariumstrontiumtitanat und ähnliche. Es sind auch Materialien mit niedriger Dielektrizitätskonstante genannt, die auf die Innenwände aufgebracht werden können. Nachteil dieses Verfahrens ist im Fall der Abscheidung von Materialien mit niedriger Dielektrizitätskonstante, dass wiederum Materialien mit einer intrinsischen Porosität eingeführt werden. Überdies bewirkt die zusätzliche Abscheidung eine Verengung der Vertiefung, so dass die Vertiefungen von vornherein breiter angelegt werden müssen, was einer Miniaturisierung bei zukünftigen Technologien entgegenläuft.

Ein weiterer Nachteil ist, dass wegen der notwendigen konformen Abscheidung wiederum nur CVD-artige Prozesse genutzt werden können, was das Verfahren der Chipfertigung aufwendiger macht und die Precursor bzw. Vorläuferverbindungen dieses CVD-Materials ebenfalls in die Poren eindringen können.

Es wäre daher wünschenswert, eine Möglichkeit bereit zu stellen, mit der die Innenwände von in Materialien mit niedriger Dielektrizitätskonstante geätzten Vertiefungen davor geschützt werden können, dass schädliche chemische Substanzen während des Chipfertigungsprozesses in oberflächenexponierte Poren eindringen und so die Dielektrizitätseigenschaften des ILD Materials nachteilig beeinflussen.

Weiterhin wäre es wünschenswert, eine Diffusion bzw. einen Übergang von Kupferionen in die interdielektrische Schicht zu vermeiden und einen möglichst guten Kontakt bzw. Sitz der Kupferbefüllung in den Gräben zu gewährleisten.

Dies wird erfindungsgemäß mit Hilfe der in Anspruch 1 aufgeführten Polymerverbindungen sowie durch die Verfahren gemäß den Ansprüchen 17, 27 und 34 erreicht.

### Kurze Beschreibung der Figuren

Fig. 1 zeigt beispielhaft einen Querschnitt durch eine Waferoberseite. Es handelt sich um eine schematische Darstellung eines "Dual-Damascene" (DD)-Stapels mit zwei dargestellten Metallisierungsebenen und einer metallischen Verbindung zwischen den beiden Ebenen.

Fig. 2 zeigt einen Querschnitt einer in eine interdielektrische Schicht geätzten Vertiefung auf einem Substrat mit darin befindlichen Hohlräumen bzw. Poren. Fig. 2 zeigt außerdem einen vergrößerten Ausschnitt, bei dem dargestellt ist, dass einzelne Poren durch Kanäle miteinander verbunden sind.

Fig. 3 zeigt eine Barriereschicht-Auskleidung der Innenwände von Gräben in Materialien mit niedriger Dielektrizitäts-konstante, wobei die Auskleidung beispielsweise aus Tantal/Tantalnitrid besteht.

In Fig. 3a ist erkennbar, dass keine vollständige Bedeckung der Innenwände erfolgt, so dass einzelne Porenhohlräume für Verunreinigungen zugänglich sind.

Fig. 3b zeigt eine entsprechende Auskleidung wie in Fig. 3a, jedoch mit mehr Barriereschichtmaterial, wobei das Beschichtungsmaterial teils in die Hohlräume verbundener Poren eindringt und so die Dielektrizitätskonstante des Materials verändert.

Fig. 4 zeigt eine Möglichkeit, das erfindungsgemäße Verfahren in die Halbleiterfertigung zu integrieren.

In Fig. 4a ist ein Querschnitt eines Teils einer Waferstruktur dargestellt mit einer Kupferunterlage, einer darüber befindlichen Schutzschicht und einer darüber befindlichen interdielektrischen Schicht, welche Poren aufweist. Weiterhin sind darüber eine Ätzstoppschicht und eine Siliciumdioxidschicht angeordnet. Der geätzte Graben ist mit einem erfindungsgemäßen Polymer beschichtet worden.

In Fig. 4b wird ein Ätzschritt durchgeführt, um die Polymerschicht aus der Vertiefung zu entfernen, wobei jedoch die Poren im Seitenwandbereich nach dem Ätzen, z.B. mit Sauerstoffplasma, mit dem erfindungsgemäßen Polymer gefüllt bleiben.

Fig. 4c zeigt die Möglichkeit einer sich wahlweise anschließenden Seitenwandauskleidung mit beispielsweise Ta/TaN.

Fig. 5 zeigt eine weitere Ausführungsform der Erfindung.

Fig. 5a entspricht Figur 4a. Anschließend erfolgt gemäß Fig. 5b eine Seitenwandauskleidung mittels beispielsweise Tantalnitrid und Tantal, die so dünn wie möglich ist, wonach in Fig. 5c ein gerichteter Ätzschritt erfolgt, bei dem die Unterseite der Vertiefung freigeätzt wird, so dass ein Kontakt zur darunterliegenden Kupfermetallisierung ermöglicht wird.

Fig. 6 zeigt schematisch die Anordnung der erfindungsgemäßen Polymermoleküle innerhalb der erfindungsgemäß aufgebrachten Polymerschicht, nach anschließender Kupferbefüllung der Vertiefungen. Die Gruppe B ist bevorzugt zum Kupfer hin angeordnet, während die Gruppe A bevorzugt zum siliciumhaltigen Material hin angeordnet ist.

### Ausführliche Beschreibung

Die vorliegende Erfindung betrifft ein Verfahren zur Versiegelung bzw. zum Schutz von in der Halbleiterfertigung eingesetzten porösen Materialien, insbesondere zum Schutz der Innenwände von in solchen Materialien befindlichen Gräben bzw. Vertiefungen oder "Vias". Die Miniaturisierung von Halbleitern führt dazu, dass vermehrt Chipstrukturen mit mehrfachen Metallisierungslagen hergestellt werden. Als Metall wird vermehrt Kupfer eingesetzt und die Kupfermetallisierungslagen sind durch Materialien mit möglichst niedriger Dielektrizitätskonstante voneinander räumlich getrennt, ausgenommen an den Kontaktbereichen zwischen verschiedenen Metallisierungsebenen. Eine Metalllage wird heute im Damascene-Verfahren hergestellt. Dabei wird standardmäßig in das Intermetalldielektrikum (interdielectric layer, ILD) eine grabenförmige Vertiefung mit rechteckigem Querschnitt geätzt und dann dieser Graben mit Metall aufgefüllt. Diese Metallbahnen sind aber weiterhin durch eine ILD-Schicht vertikal zueinander isoliert. Um nun die verschiedenen Metalllagen miteinander zu verbinden, werden an den Kontaktpunkten zusätzliche Vertiefungen durch die letztgenannte ILD-Schicht geätzt und auch diese bei dem oben genannten metallischen Auffüllprozess mit Metall gefüllt. Dieses Verfahren inklusive der Kontakte zwischen den Metallbahnen wird auch als Dual Damascene-Verfahren bezeichnet.

Während des Ätzens der Vertiefungen und weiterer sich anschließender Verfahrensschritte werden dielektrische Materialien mit niedriger Dielektrizitätskonstante jedoch leicht beschädigt. Offene Poren an den Seitenwänden von Vertiefungen können bei nachfolgenden Verarbeitungsschritten mit Materialien in Kontakt kommen, welche in die Poren eintreten und so die Eigenschaften des Dielektrikums nachteilig ändern.

Die vorliegende Erfindung stellt nun Polymerverbindungen bereit, mit der insbesondere die Seitenwände derartiger Vertiefungen ausgekleidet werden können, um die oberflächennahen Poren zu versiegeln, jedoch ohne in tieferliegende Hohlräume einzudringen. Es handelt sich dabei um Polymerverbindungen mit einer Polymerhauptkette und funktionellen Gruppen A und B,
wobei die funktionelle Gruppe A an siliciumhaltige Materialien und/oder Metallnitride anbindbar ist und die nachfolgende Struktur aufweist:

(R²-O-)₃₋ₙSiR¹ₙ-R³,

wobei n=1 oder 2 ist,
R¹ und R² jeweils eine Alkyl- oder Arylgruppe sind, wobei R¹ und R² gleich oder verschieden sein können,
und R³ eine Alkylen- oder Arylengruppe ist;
und die funktionelle Gruppe B an Kupfermetall, Kupfer(I)-oxid und/oder Kupfer(II)-oxid anbindbar ist und eine oder mehrere der nachfolgenden Strukturen aufweist: 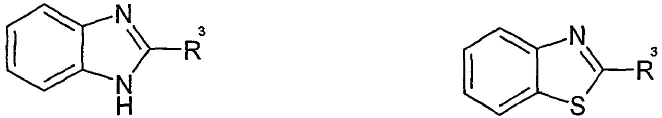 und/oder 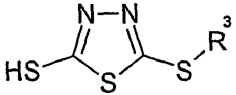 wobei R¹ und R³ wie in Gruppe A definiert sind,
und die Gruppen A und B jeweils über R³ mit der Polymerhauptkette verbunden sind.

Die vorliegende Erfindung betrifft weiterhin ein Verfahren zum Versiegeln oberflächenexponierter Poren von porösen bei der Halbleiterfertigung verwendeten Materialien mit niedriger Dielektrizitätskonstante, bei dem eine oder mehrere der folgenden Polymerverbindungen auf das poröse Material mit niedriger Dielektrizitätskonstante aufgebracht werden:
Polymerverbindungen mit einer Polymerhauptkette und funktionellen Gruppen A und B,
wobei die funktionelle Gruppe A an siliciumhaltige Materialien und/oder Metallnitride anbindbar ist und die nachfolgende Struktur aufweist:

   (R²-O-)₃₋ₙSiR¹ₙ-R³,
wobei n=1 oder 2 ist,
R¹ und R² jeweils eine Alkyl- oder Arylgruppe sind, wobei R¹ und R¹ gleich oder verschieden sein können,
und R³ eine Alkylen- oder Arylengruppe ist;
und die funktionelle Gruppe B Kupfermetall und/oder Tantal, Metalloxide, Kupfer(I)-oxid und/oder Kupfer(II)-oxid, anbindbar ist und eine oder mehrere der nachfolgenden Strukturen aufweist: 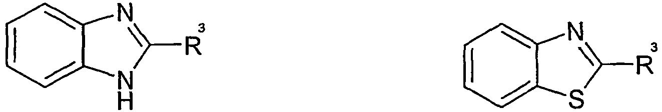 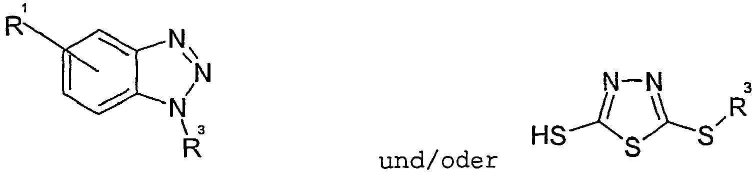
wobei R¹ und R³ wie in Gruppe A definiert sind,
   und die Gruppen A und B jeweils über R³ mit der Polymerhauptkette verbunden sind.

Unter anbindbar ist erfindungsgemäß zu verstehen, dass die jeweilige Gruppe A und B eine kovalente oder koordinative oder ionische Wechselwirkung mit einer oder mehrerer der genannten Verbindungen ausbildet.

Die erfindungsgemäßen Polymerverbindungen erfüllen insbesondere folgende Anforderungen:

Die Polymerverbindungen dringen im wesentlichen nur in die ersten oberflächenexponierten Poren in den Seitenwänden und nicht in tieferliegende Hohlräume ein.

Sie weisen eine hohe thermische Beständigkeit auf, was notwendig ist, da in nachfolgenden Verfahrensschritten, zum Beispiel Aushärten von low-k-Material, ALD (Atomic Layer Deposition), CVD etc., typischerweise Temperaturen von bis zu 400°C eingesetzt werden.

Weiterhin kann ein Wärmeausdehnungskoeffizient im Bereich des Wärmeausdehnungskoeffizienten des low-k-Materials und eventueller Materialien zur Auskleidung der Innenwände wie Tantal/Tantalnitrid gewährleistet werden.

Weiterhin weist die Polymerverbindung eine gute Haftung auf dem low-k-Material auf und auch die Haftung für ein eventuelles Auskleidungsmaterial wird nicht verringert oder wird sogar verbessert.

Insbesondere kann aufgrund der Affinität der elektronenreichen Gruppe B zu Kupfer, Kupfer(I)oxid und Kupfer(II)oxid bzw. zu Kupferionen eine Oxidation der Kupferbefüllung in der Vertiefung verhindert oder zumindest vermindert werden bzw. eine weitergehende Oxidation vermieden werden. Dadurch wird gewährleistet, dass keine Kupferionen austreten und diese in das Dielektrikum eintreten, was häufig eine ernstzunehmende Fehlerquelle ist. Aufgrund dieser Affinität oder Anbindbarkeit hinsichtlich Cu, CuO, Cu₂O und/oder Kupferionen kann erfindungsgemäß gewährleistet werden, dass bei einer Barriereschichtauskleidung mit Durchlässigkeiten eine Diffusion von Kupferionen in das ILD verhindert werden kann, da die diffundierenden Kupferionen von den Gruppen B abgefangen werden können.

Weiterhin haben die erfindungsgemäßen Polymerverbindungen keinen nachteiligen Einfluss auf den k-Wert des low-k-Materials.

Bei den Polymerhauptketten kann es sich um übliche im Handel erhältliche Polymere handeln. Bevorzugt sind die Monomere der Polymerhauptkette Ethylen, Propylen, Styren, (Meth-)acrylate, Säuren, bevorzugt Adipinsäure, (Iso-) Terephthalsäure, Alkohole, bevorzugt Butandiol, Ethandiol oder Ethylenglycol, Amine, bevorzugt Ethandiamin, Hexandiamin, Aminosäuren wie Aminocaprylsäure, ε-Caprolactam, Ether, bevorzugt Propylenoxid oder Ethylenoxid, Epoxide, bevorzugt Epichlorhydrin und/oder die Polymerhauptketten sind Silicone, deren Monomereinheiten bevorzugt Dimethyldichlorsilan und/oder Diphenyldichlorsilan sind.

Der Fachmann kann erfindungsgemäß grundsätzlich unter bekannten Polymerketten auswählen, wobei die Polymerhauptketten gemäß dem Anforderungsprofil der erfindungsgemäßen Polymere insbesondere eine hohe Temperaturbeständigkeit aufweisen sollen.

Hinsichtlich der Reste R¹ und/oder R² sind in der Gruppe A als Alkyle gerade oder verzweigte C₁ - C₆-Alkyle bevorzugt. Besonders bevorzugt sind hierunter Methyl- und Ethylgruppen.

Als Arylgruppen für R¹ und/oder R² in der Gruppe A sind substituiertes oder unsubstituiertes Phenyl, Biphenyl und/oder Naphthyl bevorzugt. Im Fall einer Substitution ist weiterhin bevorzugt, dass der Substituent ein C₁-C₁₈-Alkylrest, bevoruzgt C₁-C₆-Alkylrest ist.

Besonders bevorzugt für R¹ und/oder R² in der Gruppe A ist Phenyl als Arylgruppe.

R³ ist in der Gruppe A und/oder B unabhängig voneinander bevorzugt ein C₁-C₁₈-Alkylenrest, bevorzugt ein C₁-C₆-Alkylenrest, und/oder ein C₄-C₈-Cycloalkylenrest, bevorzugt ein C₅-C₆-Cycloalkylenrest.

Als Arylengruppe sind für R³ in der Gruppe A und/oder B unabhängig voneinander ein substituiertes oder unsubstituiertes Phenylen, Biphenylen und/oder Naphthylen bevorzugt, wobei im Fall einer Substitution der Substituent bevorzugt ein C₁-C₁₈-Alkylrest, noch bevorzugter ein C₁-C₆-Alkylrest, ist. Besonders bevorzugt ist R₃ in der Gruppe A und/oder B ein Phenylenrest.

Bevorzugt ist R¹ in der Gruppe B ein gerader oder verzweigter C₁-C₆- Alkylrest, noch bevorzugter Methyl oder Ethyl.

Damit die Polymerverbindungen nicht tiefer als notwendig in Hohlräume des low-k-Materials eindringen, weisen diese bevorzugt ein Molekulargewicht von mindestens 10 000 Da auf, wobei Molekulargewichte bis zu 10 000 000 Da möglich sind. Molekulargewichte oberhalb 10.000.000 Da sind nur noch schlecht löslich und weisen eine zu geringe Fließfähigkeit auf und sind daher aus praktischen Gründen weniger geeignet. Daher weisen die erfindungegemäßen Polymerverbindungen bevorzugt ein Molekulargewicht von 10 000 Da bis 10 000 000 Da, noch bevorzugter 20 000 - 1 000 000 Da, auf.

Eine besondere Homogenität der Polymere ist für die Erfindung nicht notwendig, solange die Polymerverbindungen leicht applizierbar sind, d.h. dass sie insbesondere in einem geeigneten Lösungsmittel löslich und schmelzbar sind.

Die Polymerverbindungen sind bevorzugt möglichst weitgehend linear, dass heißt sie weisen einen niedrigen Verzweigungsgrad auf. Dies ist aber nicht zwingend, solange die Verbindungen applizierbar sind.

Der Anteil an Gruppen A und B im jeweiligen Polymer kann in breiten Grenzen variieren. Die Menge kann über die entsprechende Stöchiometrie bei der Herstellung der Polymere gesteuert werden und die optimale Menge kann vom Fachmann bestimmt werden. Die Gruppen A und B sollten jedoch mindestens einmal pro Molekül vorhanden sein. Bevorzugt beträgt das Verhältnis der Anzahl der Gruppen A zu B etwa 30:70 bis 70:30, ebenfalls bevorzugt 40:60 bis 60 :40, und ebenfalls bevorzugt etwa 50:50.

Die erfindungsgemäßen Polymerverbindungen können für sich oder bevorzugter gelöst in einem Lösungsmittel aufgebracht werden. An das Lösungsmittel ist möglichst die Anforderung zu stellen, dass es die low-k-Materialschicht nicht anlöst und andererseits keinen nachteiligen Effekt auf die Dielektrizitätseigenschaften des low-k-Materials aufweist, falls Reste hiervon in Poren eindringen und dort verbleiben. Geeignete Lösungsmittel sind Kohlenwasserstoffe wie Hexan, Cyclohexan, Heptan, Ether, insbesondere THF, Ketone, insbesondere Methylethylketon. Auch Toluol ist erfindungsgemäß bevorzugt. Die vorliegende Erfindung umfasst daher erfindungsgemäß auch eine Zusammensetzung, welche ein oder mehrere Polymerverbindungen der vorliegenden Erfindung sowie ein oder mehrere Lösungsmittel enthält oder bevorzugt hieraus besteht. Als Lösungsmittel sind bevorzugt: Alkane, bevorzugt C₅-C₁₀-Isoalkane wie Hexan und/oder Heptan, Cycloalkane, bevorzugt Cyclopentan und/oder Cyclohexan, Ether, bevorzugt C₂-C₈-Dialkylether und/oder Tetrahydrofuran, und/oder Ketone, insbesondere C₁-C₈-Dialkylkethone, bevorzugt Methylethylketon, oder Toluol.

Die Gruppe R³ bildet sowohl für die Gruppe A als auch die Gruppe B die Verbindung zur Polymerhauptkette. Die Gruppen A und/oder B können nach herkömmlichen, dem Fachmann bekannten Verfahren, mit der Polymerhauptkette verbunden werden, und beispielsweise über Reaktivgruppenchemie zwischen Polymer (z. B. Isocyanat, Anhydrid, Säurechlorid, Epoxid) und Komponente A und/oder B (z. B. Hydroxyamino- oder Mercaptogruppen) eingeführt werden.

Bevorzugt befindet sich die Gruppe A vermehrt an einem Ende des Polymermoleküls und die Gruppe B am anderen Ende des Polymermoleküls.

Die erfindungsgemäßen Polymerverbindungen sind insbesondere zum Schutz poröser interdielektrischer Schichtmaterialien mit oberflächenexponierten Hohlräumen bei der Chipherstellung geeignet.

Als interdielektrische Materialien(low-k-Materialien) kommen insbesondere siliciumhaltige Materialien wie kohlenstoffdotiertes Siliciumdioxid, Silsesquioxane wie Hydrogen-Silsesquioxane (HSQ) oder Methyl-Silsesquioxane (MSQ) in und/oder die nachfolgend beispielhaft aufgeführten, derzeit üblicherweise verwendeten low-k Materialien in Frage: XLK (Hydrogen-Silsesquioxan, Dow Corning), 9-2222(Boss) (HSQ/MSQ , Dow Corning), LKD 5109 (MSQ, JSR), Zirkon (MSQ, Shipley), SiLK/p-SiLK (Version1-9) (organische Verbindung mit geringem Siliciumanteil, Dow Chemical), Black Diamond(I/II) (Applied Material).

Die Gruppe A bindet bevorzugt an siliciumhaltige Materialien wie Silicate, Silsesquioxane, Siliciumcarbid oder Metallnitride, wobei Siliciumcarbid und Metallnitride, insbesondere Siliciumnitrid, bei der Chipherstellung häufig als Schutzschichten auf ILD eingesetzt werden und somit ebenfalls Teil der zu befüllenden Vertiefung sind. Die Bindung erfolgt über die Gruppe A entweder kovalent oder auf andere Weise adhäsiv, bspw. durch koordinative Wechselwirkungen und/oder ionische Wechselwirkungen.

Die vorliegende Erfindung betrifft weiterhin ein Verfahren zum Versiegeln oberflächenexponierter Poren von porösen, bei der Halbleiterfertigung verwendeten Materialien mit niedriger Dielektrizitätskonstante, bei dem eine Schicht einer Polymerverbindung gemäß der vorliegenden Erfindung auf das poröse Material mit niedriger Dielektrizitätskonstante aufgebracht wird.

Die Schichtdicke der aufgebrachten Polymerverbindung beträgt bevorzugt 0,5 - 10 nm, weiterhin bevorzugt 1 - 5 nm, ebenfalls bevorzugt kleiner ungefähr 5 nm und entspricht vorzugsweise einer Monolage des entsprechenden verwendeten Polymers.

Bei der derzeitig eingesetzten 150nm-Technologie beträgt die Metallbahnbreite 150nm, die ILD-Breite 150nm, die Metallbahnhöhe ca. 180-300nm. Die Schichtdicke des erfindungsgemäßen Polymers beträgt möglichst 5 nm oder weniger. Für zukünftige Technologien werden die Metall/ILD-Breiten als auch die -Höhen schmaler. Für die 45nm Technologie werden Metallbahn-/ILD-Breiten von 45nm verlangt. Wird neben einer Monolage Polymer noch eine Zwischenschicht (Liner, Barriereschicht) (z.B. 10nm TaN) aufgebracht, bleibt nicht mehr viel Raum für eine Kupferbahn. Es ist ein Vorteil der vorliegenden Erfindung, dass die erfindungsgemäßen Polymerverbindungen in sehr geringen Schichtdicken aufgebracht werden können.

Ein weiterer Vorteil ist, dass aufgrund der erfindungsgemäßen Beschichtung sogar auf eine weitere Auskleidung der Innenwände vor Kupferbefüllung verzichtet werden kann.

Die Polymerverbindung kann für sich, oder gelöst in einem geeigneten Lösungsmittel, durch Spin-on-Verfahren oder durch Eintauchen auf den zu behandelnden Bereich aufgebracht werden.

Nach dem Aufbringen erfolgt in einer bevorzugten Ausführungsform ein Erwärmungsschritt, um die aufgebrachte Schicht zu trocknen und/oder um Lösungsmittel und/oder flüchtige Bestandteile zu entfernen, insbesondere wenn die Verbindung zusammen mit einem Lösungsmittel aufgebracht werden.

In einer bevorzugten Ausführungsform erfolgt nach dem Aufbringen der Polymerverbindung und ggf. dem Erwärmungsschritt ein Ätzschritt, um überschüssige Polymerverbindung aus der Vertiefung zu entfernen. Hiernach kann sich in einer besonders bevorzugten Ausführungsform direkt eine Befüllung mit Kupfer anschließen. Dadurch bietet sich die Möglichkeit, die Vertiefungsausmaße im Vergleich zu herkömmlichen Verfahren, bei denen erst noch eine Auskleidung der Innenwände mit einer Barriereschicht erfolgt, deutlich zu verringern, was eine weitere Miniaturisierung erlaubt.

Alternativ kann in einer ebenfalls bevorzugten Ausführungsform eine Auskleidung der Innenwand nach herkömmlichen Verfahren erfolgen, wobei aber die Schichtdicke der Barriereschicht bevorzugt deutlich geringer als üblich ist. Dies kann durch die vorherige Beschichtung mit den erfindungsgemäßen Polymeren erreicht werden und begünstigt ebenfalls eine Miniaturisierung.

Nach dem Aufbringen der Barriereschicht, beispielsweise einer Tantal/Tantalnitridschicht, kann bevorzugt anschließend ein gerichteter Ätzschritt durchgeführt werden, um die Barriereschicht und überschüssige Polymerverbindung vom Boden der Vertiefung zu entfernen. Hieran kann sich wieder eine Kupferbefüllung anschließen.

Übliche und erfindungsgemäß verwendbare Barriereschichtmaterialien sind Metalle, insbesondere Titan und/oder Tantal, Metallcarbide, insbesondere Wolframcarbid und/oder Siliciumcarbid, Metallnitride, insbesondere Wolframnitrid, Titannitrid und/oder Tantalnitrid, und/oder Metallcarbonitride, insbesondere Wolframcarbonitrid.

Das erfindungsgemäße Verfahren wird insbesondere in die Halbleiterfertigung integriert und es wird ein Verfahren zur Integration poröser Materialien mit niedriger Dielektrizitätskonstante in die Halbleiterfertigung bereitgestellt, mit den Schritten:
a. Ätzen einer Vertiefung in eine auf einem Substrat befindliche Schicht eines Materials mit niedriger Dielektrizitätskonstante (ILD),
b. Aufbringen einer Polymerverbindung wie in dem oben beschriebenen Verfahren bzw. wie in Anspruch 17 definiert, um die Seitenwände der Vertiefungen zu bedecken,
c. Füllen der Vertiefungen mit Metall.

Nach dem Aufbringen der Polymerverbindung durch Spin-on-Verfahren oder Eintauchen wird vorzugsweise ein Hitzebehandlungsschritt durchgeführt, um die aufgebrachte Polymerverbindung zu festigen und/oder_um das Lösungsmittel und eventuelle flüchtige Bestandteile zu verdampfen.

Das Substrat ist bevorzugt eine Metallisierungslage eines Wafers, weiterhin bevorzugt eine Kupfermetallisierungsebene. Die Vertiefung wird erfindungsgemäß ebenfalls mit Kupfer befüllt.

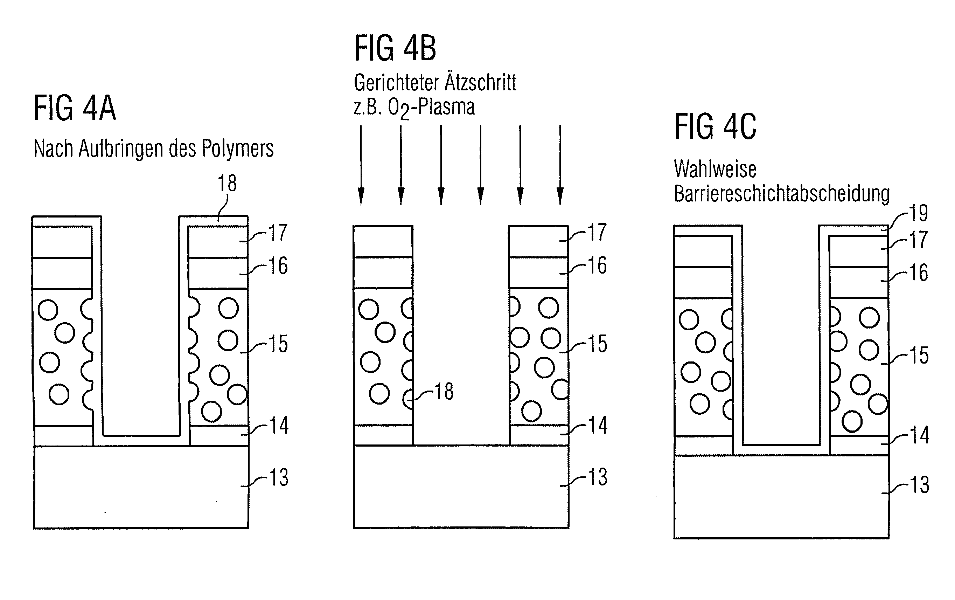

Nachdem die erfindungsgemäßen Polymerverbindungen aufgebracht wurden, kann in einer bevorzugten Ausführungsform der Erfindung ein Ätzschritt erfolgen, um die Polymerschicht wieder zu entfernen, ausgenommen von den mit der Polymerverbindung gefüllten Poren in den Seitenwänden der Vertiefung. Dieser Ätzschritt kann nach herkömmlichen Verfahren, z.B. mittels Trockenätzen in Sauerstoffplasma, erfolgen. Anschließend kann wahlweise eine Auskleidung der Innenwände mit einer Barriereschicht, z.B. mit Tantal/Tantalnitrid, nach herkömmlichen Verfahren erfolgen, wobei diese Schicht bevorzugt so dünn wie möglich sein sollte. Beispielsweise kann nach herkömmlichen Verfahren zunächst eine 15 nm dicke TaN-Schicht und anschließend eine 10 nm Ta-Schicht aufgetragen werden. Aufgrund der Befüllung der Oberflächenlagenporen mit den erfindungsgemäßen Polymerverbindungen kann die Tantal/Tantalnitrid-Beschichtung auch wesentlich dünner ausfallen, was im Zuge der Miniaturisierung von Halbleiterstrukturen besonders vorteilhaft ist. Anschließend kann die Vertiefung mit Metall, bevorzugt Kupfer, befüllt werden, um den Kontakt zur darunter liegenden Metallbahn, bevorzugt einer Kupfermetallisierungsebene, herzustellen. Dieses Verfahren ist auch in Fig. 4 schematisch dargestellt.

In einer besonders bevorzugten Ausführungsform der Erfindung kann auch direkt nach einem Ätzen nach Schritt b. eine Befüllung mit Metall, insbesondere Kupfer, erfolgen, ohne vorher eine Tantal/Tantalnitrid- oder andere Barriereschicht abzuscheiden. Dadurch können die Ausdehnungen der geätzten Vertiefungen nochmals verringert werden.

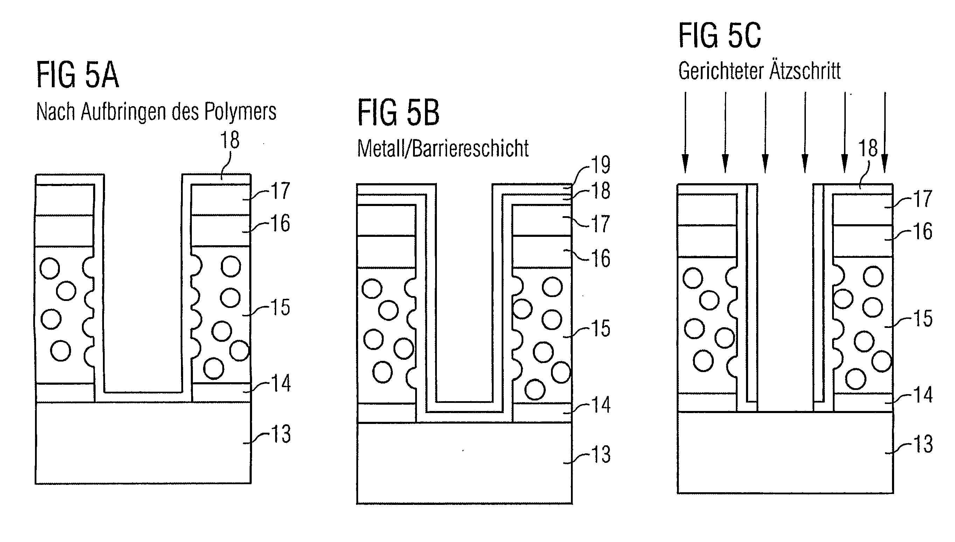

In einer weiteren Ausführungsform der Erfindung kann bevorzugt nach Aufbringen der Polymerverbindung eine Barriereschicht abgeschieden werden, welche beispielsweise der oben beschriebenen Tantal/Tantalnitridschicht entspricht. Anschließend kann ein gerichtetes Ätzen erfolgen, so dass der Boden der Vertiefung frei geätzt wird, so dass ein Kontakt zum darunterliegenden Kupfer einer Metallisierungsebene hergestellt werden kann. Bei diesem Verfahren werden beim Ätzen im wesentlichen lediglich die obere Barriereschicht und die am Boden befindliche Barriereschicht mit der am Boden befindlichen Polymerverbindungsschicht weggeätzt. Diese Ausführungsform ist schematisch in Fig. 5 dargestellt.

Die vorliegende Erfindung umfasst weiterhin ein Verfahren zur Verbindung von Metallisierungsebenen bei der Halbleiterfertigung, wobei:
a. auf eine untere Metallisierungsebene eine Schicht eines Materials mit niederiger Dielektrizitätskonstante (ILD) aufgebracht wird,
b. in die ILD nach herkömmlichen Verfahren Vertiefungen geätzt werden,
c. eine Polymerverbindung gemäß den bereits beschriebenen Verfahren der vorliegenden Erfindung bzw. wie in Anspruch 17 definiert aufgebracht wird, um die Seitenwände der Vertiefungen zu bedecken und oberflächenexponierte Poren zu versiegeln,
d. die Vertiefungen mit einem Metall befüllt werden, um eine Verbindung zu der unteren Metallisierungsebene herzustellen.

Bei diesem Verfahren kann insbesondere bevorzugt auch ohne weitere Auskleidung der Innenwände eine Befüllung der Vertiefungen mit Kupfer erfolgen.

Das Verfahren kann aber, wie oben beschrieben, auch mit einer Barriereschicht Auskleidung durchgeführt werden, wobei die ebenfalls oben beschriebenen, und in Fig. 4 und 5 dargestellten Möglichkeiten der Verfahrensführung erfindungsgemäß vorgesehen und bevorzugt sind.

Bei den erfindungsgemäßen Verfahren ist besonders bevorzugt, wenn die Gruppe B eine der folgenden Gruppen ist: 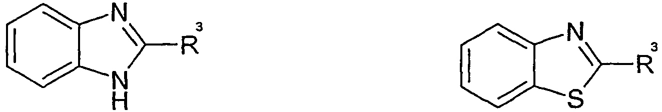 und/oder 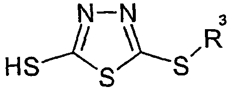 wobei R¹ und R³ wie oben definiert sind. Mit diesen Resten wurden besonders gute Ergebnisse bezüglich der Abdichtungseigenschaften und bezüglich der Funktionsfähigkeit der so behandelten Wafer erzielt.

In einer weniger bevorzugten Ausführungsform ist die Gruppe B eine Verbindung der Formel (Benzotriazol): 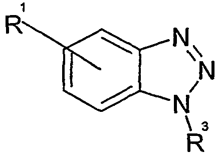 wobei R¹ und R³ wie oben definiert sind.

Die Erfindung wird im folgenden anhand weiterer Figuren näher erläutert.

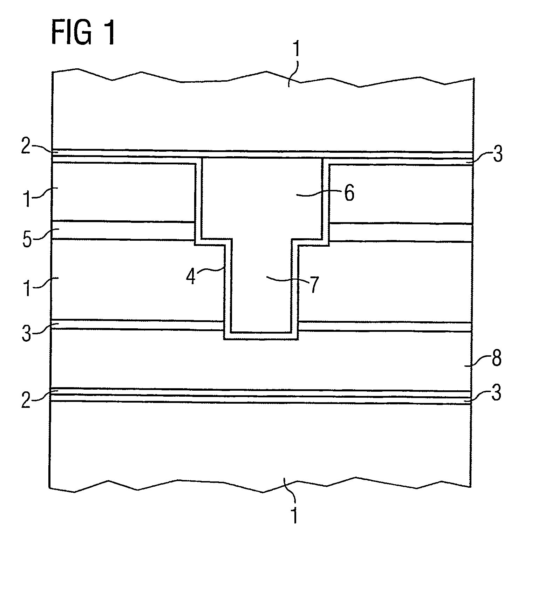

Fig. 1 zeigt beispielhaft einen Querschnitt durch eine Waferoberseite. Es handelt sich um eine schematische Darstellung eines "Dual-Damascene" (DD)-Stapels mit zwei dargestellten Metallisierungsebenen.

In der Figur bedeutet IMD (1) jeweils intermetallisches Dielekrikum, was einem low-k-Material bzw. ILD entspricht. Zwischen verschiedenen IMD-Schichten und Kupfer befinden sich üblicherweise Ätzstopschichten bzw. Schutzschichten (z.B. Nitrid (2) und/oder SiC (3)). Das Via (7) ist mit Kupfer gefüllt und die Wände des Vias sind mit einer Barriereschicht (4), z. B. Ta/TaN, beschichtet. Weiterhin befindet sich eine eingebettete Hartmaske (5) auf der IMD-Schicht, welche das Via (7) umgibt. Das mit Kupfer gefüllte Via (7) verbindet die untere Metallleitung (8) mit der oberen Metallleitung (6).

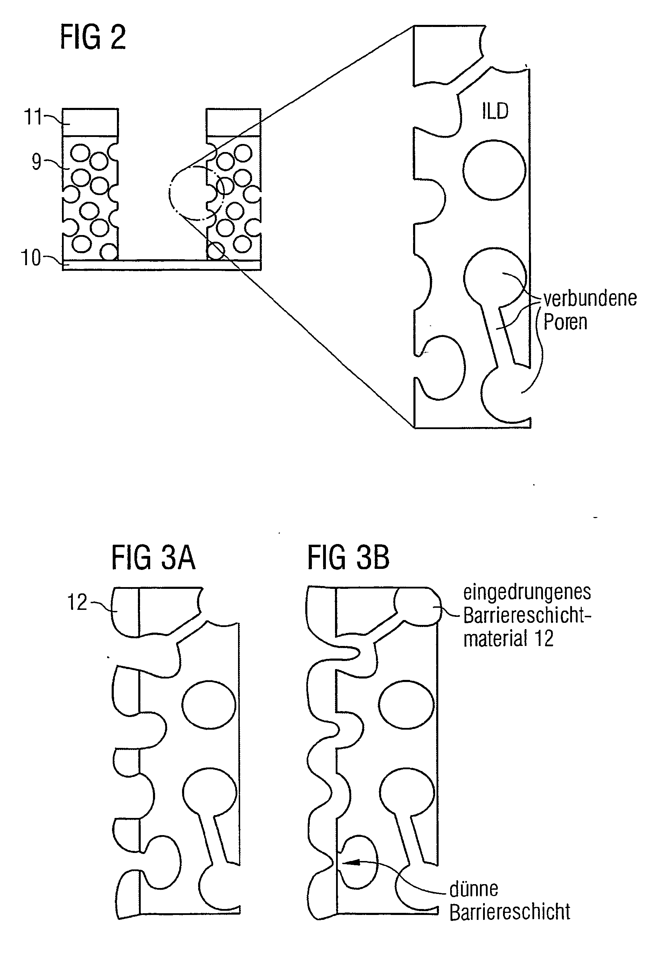

In Fig. 2 ist schematisch die Porosität der IMD bzw. ILD-Schichten (9) dargestellt. Das ILD (9) befindet sich hier auf einer Unterlage (10) aus beispielsweise SiC worunter sich die nächste Kupfermetallisierung befindet (nicht dargestellt). Die ILD-Schicht ist weiterhin auf der Oberseite von einer Hilfs- und/oder Schutzschicht (11) aus beispielsweise SiC abgedeckt. Die Figur zeigt weiterhin einen vergrößerten Ausschnitt mit Hohlräumen und miteinander durch Kanäle verbundenen Hohlräumen. Die oben befindliche Schutzschicht (11) ist typischerweise SiC und fungiert hier als üblicherweise als Schutz- und auch als Stoppschicht für das Chemisch Mechanische Polieren (CMP). Die Figur zeigt, dass durch die die Poren verbindenden Kanäle verunreinigende Substanzen tiefer in die ILD-Schicht eindringen können und so deren Dielektrizitätseigenschaften beeinflussen können.

Fig. 3 zeigt, wie herkömmlicherweise die Innenwände von Vertiefungen in ILD mittels Barriereschichten (12) ausgekleidet bzw. geschützt werden. Aufgrund der Porosität kann dabei einerseits nicht die gesamte Innenwand bedeckt werden, .so dass Innenräume immer noch für verunreinigende Substanzen zugänglich sind (Fig. 3 a). Bei einer größeren Menge von abgeschiedenem Barrierematerial kann diese in vorhandene Hohlräume eindringen und so die Dielektrizitätseigenschaften des low-k-Materials negativ beeinflussen. Außerdem tritt an oberflächennahen Innenraumbereichen eine Verdünnung der Barriereschicht auf, was die Fehlerquote bei nachfolgender Kupferbefüllung erhöhen kann.

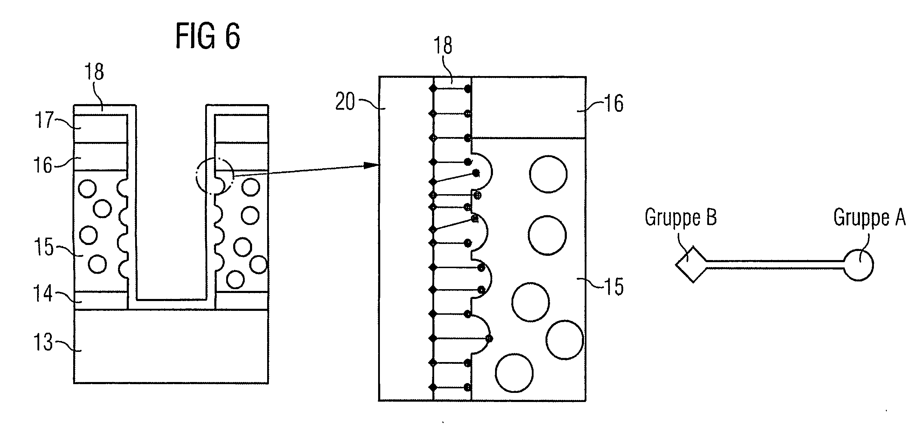

Fig. 6 zeigt die Anordnung der erfindungsgemäßen Polymerverbindungen schematisch innerhalb der erfindungsgemäßen Polymerschicht, wenn die Vertiefung anschließend mit Kupfer (20) oder einer Barriereschicht (20) gefüllt wurde. Die Gruppe A geht eine Bindung mit dem siliciumhaltigen Material der low-k-Schicht und dem Material der darüber befindlichen Schutzschicht, z.B. Siliciumnitrid, Siliciumcarbid, ein. Außerdem können im Polymer befindliche Gruppen B an Kupferatome der Befüllung binden. Die funktionellen Gruppen B sind überdies in der Lage, eine Oxidation von Kupfer zu verhindern. Dies verhindert wiederum eine Kupferionenbildung, welche eine Elektromigration von Kupfer in das ILD-Material auslösen könnte. Vorzugsweise richten sich die Polymerverbindungen mit den endständigen funktionellen Gruppen B und A so aus, dass eine stabile Grenzschicht gebildet wird.

Die erfindungsgemäßen Verfahren können überall dort bei der Halbleiterfertigung eingesetzt werden, wo ILD-Materialien mit geätzten Vertiefungen auftauchen. Das erfindungsgemäße Verfahren kann daher bei der Herstellung von Halbleitervorrichtungen wie MOSFETs, Speichereinrichtungen, Logikeinrichtungen bzw. grundsätzlich im BEOL-Bereich benutzt werden.

### Beispiele

Die Materialtauglichkeit der in der erfindungsgemäßen Polymerverbindungen kann in folgender Weise erfolgen:
1. In der ersten Phase der Versuche wird auf blankem Wafer gearbeitet, der ganzflächig mit dem zu versiegelnden Material beschichtet ist. Hier wird auf das zu versiegelnde Material die Polymerverbindung mit den Gruppen A und B aufgetragen und anschliessend mittels folgendender Methoden die Dichtheit der Schicht überprueft.
   a. Schichtdickenmessung (Bestimmung der Schichtdicke)
   b. Ellipsometrische Porositätsmessungen(EP): Mittels der Aufnahme von z.B. Toluol, kann die Porengröße des darunter liegenden Materials gemessen werden. Falls keine Porengröße gemessen werden kann, ist die Schicht dicht.
2. In der zweiten Phase kann die Methode an strukturierten Wafern getestet werden. Hierzu werden die mit dem ILD beschichteten Wafer nach dem Strukturieren mit der Polymerlösung beschichtet und in anschließenden Tests auf Dichtheit geprüft (s.o.). Dies kann wie oben beschrieben mittels EP gemacht werden und/oder durch elektrische Evaluierung des bis zu Ende prozessierten Wafers getestet werden.

Elektrische Dichtigkeitsmessungen können z.B. die Bestimmung der Dielektrizitätskonstanten oder der Durchbruchspannung zwischen zwei Metallbahnen sein. Bei beiden Methoden wird eine Veränderung des Parameters beurteilt.

### Beispiel 1

Strukturierte Wafer, d.h. Wafer mit freiliegenden Wänden eines low k-Dielektrikums (kohlenstoffdotiertes Silicium) wurden für 1 h in 10 Gew.-% Lösung des erfindungsgemäßen Polymers in Cyclohexan eingetaucht. Alternativ kann die Lösung auch durch Spin-on-Verfahren aufgebracht werden. Als Gruppe A zur Herstellung des Polymers wurde jeweils Methylendimethyl-methoxysilan verwendet, d.h. die Gruppe A wurde bspw. über die Verbindung (Chlormethyl)-dimethylmethoxysilan in die Polymerkette eingeführt, so dass die Gruppe A durch eine Methylengruppe mit der Polymerhauptkette verbunden war. Als Gruppe B wurden jeweils die folgenden Reste verwendet, wobei R³ zur Verbindung mit der Polymerhauptkette jeweils eine Methylengruppe war.

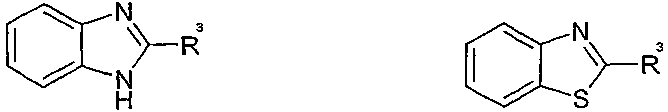

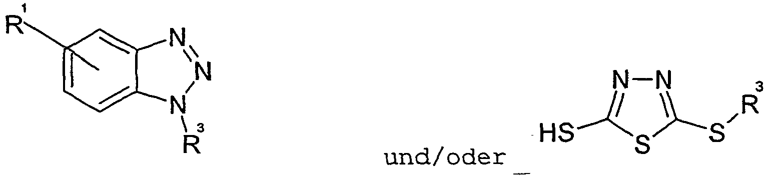

Für den Fall der Gruppe B als Benzotriazolrest war R¹ eine Methylgruppe an der ortho-Position zu dem C-Atom, das mit der N-R³-Gruppe verbunden ist. Als Polymerhauptkette wurde Polypropylen verwendet.

Die Gruppen A und B lagen in dem Polymer etwa in gleichen Verhältnissen vor. Das Molekulargewicht der Verbindungen betrug jeweils etwa 40000 Da.

Nach Beschichten wurden die Waferproben im Ofen bei etwa 250°C unter Inertgasatmosphäre für 1h getrocknet, um restliches Lösungsmittel zu entfernen. Die aufgebrachte Schicht wies eine Schichtdicke von etwa 3 nm (Polymermonolage) auf.

Mittels eines gerichteten kurzen N₂/H₂-Ätzplasmaschritts wird selektiv der Boden von in dem Wafer befindlichen Vertiefungen geätzt, und die Oberfläche vom Polymer freigeätzt. Auf den Seitenwänden und in den Poren blieb hierbei das Polymer erhalten.

Anschließend wurde eine metallische Barriere (Tantal) mittels PVD aufgebracht.

Eine elektrische Evaluierung der bis zu Ende prozessierten Wafer ergab jeweils hervorragende Eigenschaften der so hergestellten Wafer, d.h. eine Verschlechterung der interdielektrischen Eigenschaften konnte nicht festgestellt werden. Lediglich im Fall der Verbindungen mit einem Benzotriazolrest als Gruppe B wurden gelegentlich Fehler festgestellt.

### Beispiel 2

Das obige Verfahren wurde bis einschließlich der Entfernung des Lösungsmittels im Ofen wiederholt.

Anschließend wurde auf die so abgeschiedene Polymermonolage mittels ALCVD oder PVD eine nichtmetallische 5nm dünne SiC-Schicht (eine sogenannte "Liner"-Schicht)aufgebracht.

Mittels eines kurzen gerichteten Ätzschritts (CF₄/H₂-Ätzplasma) wurde der Boden der Vertiefungen freigeätzt. An den Seitenwänden blieb die Polymerschicht und die "Liner"-schicht erhalten.

Als metallische Barriereschicht wurde anschließend eine 5nm dünne Ta-Schicht verwendet, die mittels PVD-Verfahren aufgebracht wurde.

Wie in Beispiel 1 ergab eine elektrische Evaluierung der bis zu Ende prozessierten Wafer jeweils hervorragende Eigenschaften der so hergestellten Wafer, d.h. eine Verschlechterung der interdielektrischen Eigenschaften konnte nicht festgestellt werden. Lediglich im Fall der Verbindungen mit einem Benzotriazolrest als Gruppe B wurden wieder gelegentlich Fehler festgestellt.

Entsprechende Ergebnisse wurden auch erhalten, wenn die Reste R³ in Gruppe B variiert wurden, z.B. mit R³ = Ethyl.

### Beispiel 3

Weiterhin wurden zur Bestimmung der Porositäten die oben genannten Verbindungen auf einen, mit einem porösen Low-K Material beschichteten, Si-Wafer aufgetragen, um diesen ganzflächig mit den Polymerverbindungen zu beschichten. Ellipsometrische Porositätsmessungen mit Toluol ergaben jeweils, dass die aufgebrachten Schichten keine Porosität aufwies. Lediglich im Fall der Benzotriazolderivate wurde gelegentlich eine geringe Porosität festgestellt.

### Bezugszeichenliste

- 1: interdielektrische Schicht (ILD), intermetallische Schicht (IMD) oder low k Material
- 2: Schutzschicht, Nitrid
- 3: Schutzschicht, SiC
- 4: Barriereschicht, z.B. Ta/TaN
- 5: eingebettete Hartmaske
- 6: obere Metallleitung
- 7: Vertiefung/Via
- 8: untere Metallleitung
- 9: ILD
- 10: Unterlage
- 11: Schutzschicht, z.B. SiC
- 12: Barriereschicht
- 13: Kupfer
- 14: Ätzstoppschicht
- 15: ILD
- 16: Ätzstoppschicht, z.B. SiC
- 17: SiO₂
- 18: erfindungsgemäße Polymerverbindung
- 19: Barriereschicht, z.B. Ta/TaN
- 20: Metallschicht, z.B. Kupfer oder Barriereschicht, z.B. Ta/TaN

## Patentansprüche

1. Polymerverbindungen mit einer Polymerhauptkette und funktionellen Gruppen A und B,
wobei die funktionelle Gruppe A an siliciumhaltige Materialien und/oder Metallnitride anbindbar ist und die nachfolgende Struktur aufweist:
(R²-O-)₃₋ₙSiR¹ₙ-R³,
wobei n=1 oder 2 ist,
R¹ und R² jeweils eine Alkyl- oder Arylgruppe sind, wobei R¹ und R² gleich oder verschieden sein können,
und R³ eine Alkylen- oder Arylengruppe ist;
und die funktionelle Gruppe B an Kupfermetall und/oder Tantal, Metalloxide, Kupfer(I)-oxid und/oder Kupfer(II)-oxid, anbindbar ist und eine oder mehrere der nachfolgenden Strukturen aufweist: 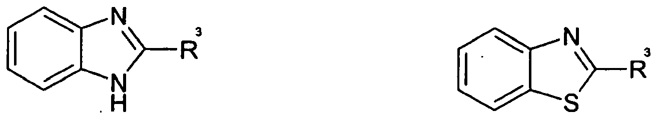 und/oder 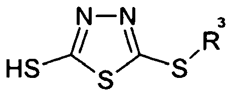 wobei R³ wie in Gruppe A definiert ist,
und die Gruppen A und B jeweils über R³ mit der Polymerhauptkette verbunden sind.

2. Polymerverbindungen nach Anspruch 1,
**dadurch gekennzeichnet,**
**dass** die Monomere der Polymerhauptkette Ethylen, Propylen, Styren, (Meth-)acrylate, Säuren, bevorzugt Adipinsäure,(Iso-) Terephthalsäure, Alkohole, bevorzugt Butandiol, Ethandiol oder Ethylenglycol, Amine, bevorzugt Ethandiamin, Hexandiamin, Aminosäuren wie Aminocaprylsäure, ε-Caprolactam, Ether, bevorzugt Propylenoxid oder Ethylenoxid, Epoxide, bevorzugt Epichlorhydrin sind und/oder die Polymerhauptketten Silicone sind, deren Monomereinheiten bevorzugt Dimethyldichlorsilan und/oder Diphenyldichlorsilan sind.

3. Polymerverbindungen nach einem oder mehreren vorhergehenden Ansprüche,
**dadurch gekennzeichnet,**
**dass** R¹ und/oder R² in der Gruppe A gerade oder verzweigte C₁-C₆-Alkyle sind, bevorzugt Methyl oder Ethyl.

4. Polymerverbindungen nach einem oder mehreren der vorhergehenden Ansprüche,
**dadurch gekennzeichnet,**
**dass** R¹ und/oder R² in der Gruppe A ein substituiertes oder unsubstituiertes Phenyl, Biphenyl und/oder Naphthyl ist.

5. Polymerverbindungen nach Anspruch 4,
**dadurch gekennzeichnet,**
**dass** der Substituent ein C₁-C₁₈-Alkylrest, bevorzugt C₁-C₆-Alkylrest ist.

6. Polymerverbindungen nach einem oder mehreren der vorhergehenden Ansprüche,
**dadurch gekennzeichnet,**
**dass** R¹ und/oder R² in der Gruppe A ein Phenylrest ist.

7. Polymerverbindungen nach einem oder mehreren der vorhergehenden Ansprüche,
**dadurch gekennzeichnet,**
**dass** R³ in der Gruppe A ein C₁-C₁₈-Alkylenrest, bevorzugt ein C₁-C₆-Alkylenrest ist, und/oder ein C₄-C₈-Cycloalkylenrest, bevorzugt ein C₅-C₆-Cycloalkylenrest.

8. Polymerverbindungen nach einem oder mehreren der vorhergehenden Ansprüche,
**dadurch gekennzeichnet,**
**dass** R³ in der Gruppe B ein C₁-C₁₈-Alkylenrest, bevorzugt ein C₁-C₆-Alkylenrest ist, und/oder ein C₄-C₈-Cycloalkylenrest, bevorzugt ein C₅-C₆-Cycloalkylenrest.

9. Polymerverbindungen nach einem oder mehreren der vorhergehenden Ansprüche, ,
**dadurch gekennzeichnet,**
**dass** R³ in der Gruppe A und/oder B unabhängig voneinander ein substituiertes oder unsubstituiertes Phenylen, Biphenylen und/oder Naphthylen ist, wobei im Fall einer Substitution der Substituent bevorzugt ein C₁-C₁₈-Alkylrest, noch bevorzugter ein C₁-C₆-Alkylrest ist.

10. Polymerverbindungen nach einem oder mehreren der vorhergehenden Ansprüche,
**dadurch gekennzeichnet,**
**dass** R³ in der Gruppe A und/oder B unabhängig voneinander ein Phenylenrest ist.

11. Polymerverbindungen nach einem oder mehreren der vorhergehenden Ansprüche,
**dadurch gekennzeichnet,**
**dass** R¹ in der Gruppe A ein gerader oder verzweigter C₁-C₆-Alkylrest ist, bevorzugt Methyl oder Ethyl.

12. Polymerverbindungen nach einem oder mehreren der vorhergehenden Ansprüche,
**dadurch gekennzeichnet,**
**dass** die Polymere ein Molekulargewicht von 10 000 Da bis 10 000 000 Da, bevorzugt 20 000 - 1 000 000 Da aufweisen.

13. Polymerverbindungen nach einem oder mehreren der vorhergehenden Ansprüche,
**dadurch gekennzeichnet,**
**dass** die Polymerverbindungen linear sind.

14. Zusammensetzung, enthaltend Polymerverbindungen nach einem oder mehreren der vorhergehenden Ansprüche, sowie ein oder mehrere Lösungsmittel.

15. Zusammensetzung nach Anspruch 14,
**dadurch gekennzeichnet,**
**dass** als Lösungsmittel Alkane, bevorzugt C₅-C₁₀-Isoalkane wie Hexan und/oder Heptan, Cycloalkane, bevorzugt Cyclopentan und/oder Cyclohexan, Ether, bevorzugt C₂-C₈-Dialkylether und/oder Tetrahydrofuran, und/oder Ketone, insbesondere C₁-C₈-Dialkylkethone, bevorzugt Methylethylketon, eingesetzt werden.

16. Verfahren zum Versiegeln oberflächenexponierter Poren von porösen bei der Halbleiterfertigung als Trennschichten zwischen Metallisierungsebenen verwendeten Materialien mit niedriger Dielektrizitätskonstante, bei dem eine oder mehrere der folgenden Polymerverbindungen:
Polymerverbindungen mit einer Polymerhauptkette und funktionellen Gruppen A und B,
wobei die funktionelle Gruppe A an siliciumhaltige Materialien und/oder Metallnitride anbindbar ist und die nachfolgende Struktur aufweist:
(R²-O-)₃₋ₙSiR¹ₙ-R³,
wobei n=1 oder 2 ist,
R¹ und R² jeweils eine Alkyl- oder Arylgruppe sind, wobei R¹ und R² gleich oder verschieden sein können,
und R³ eine Alkylen- oder Arylengruppe ist;
und die funktionelle Gruppe B an Kupfermetall und/oder Tantal, Metalloxide, Kupfer(I)-oxid und/oder Kupfer(II)-oxid, anbindbar ist und eine oder mehrere der nachfolgenden Strukturen aufweist: 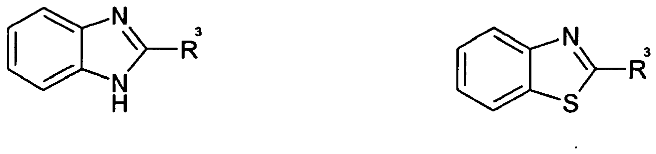 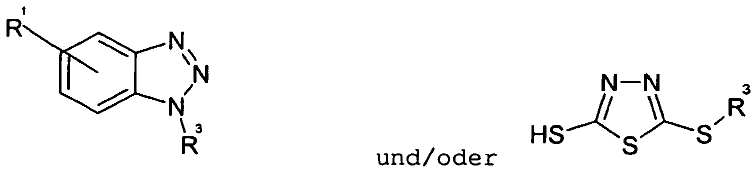
wobei R¹ und R³ wie in Gruppe A definiert sind,
und die Gruppen A und B jeweils über R³ mit der Polymerhauptkette verbunden sind,
auf das poröse Material mit niedriger Dielektrizitätskonstante aufgebracht werden.

17. Verfahren nach Anspruch 16,
**dadurch gekennzeichnet,**
**dass** es sich bei den interdielektrischen Schichten um siliciumhaltige Materialien wie kohlenstoffdotiertes Siliciumdioxid, Silsesquioxane wie Hydrogen-Silsesquioxane (HSQ) oder Methyl-Silsesquioxane (MSQ).

18. Verfahren nach Anspruch 16 oder 17,
**dadurch gekennzeichnet,**
**dass** die Schichtdicke der aufgebrachten Polymerverbindungsschicht einer Monolage entspricht.

19. Verfahren nach einem der Ansprüche 16 - 18,
**dadurch gekennzeichnet,**
**dass** die Dicke der aufgebrachten Polymerverbindungsschicht 0,5 - 10 nm, bevorzugt 1 - 5 nm, beträgt.

20. Verfahren nach einem der Ansprüche 16 - 19,
**dadurch gekennzeichnet,**
**dass** die Polymerverbindung durch ein Spin-on-Verfahren oder durch Eintauchen aufgebracht wird.

21. Verfahren nach einem der Ansprüche 16 - 20,
**dadurch gekennzeichnet,**
**dass** nach dem Aufbringen ein Erwärmungsschritt durchgeführt wird, um die aufgebrachte Schicht zu trocknen und/oder um Lösungsmittel und flüchtige Bestandteile zu entfernen.

22. Verfahren nach einem der Ansprüche 16 - 21,
**dadurch gekennzeichnet,**
**dass** die Polymerverbindungen auf die Innenwände einer bei der Chipfertigung in eine Orteslanger Dielectric (ILD) geätzten Vertiefung gebracht werden.

23. Verfahren nach einem der Ansprüche 16 - 22,
**dadurch gekennzeichnet,**
nach dem Aufbringen der Polymerverbindung ein Ätzschritt durchgeführt wird, um überschüssige Polymerverbindung aus der Vertiefung zu entfernen.

24. Verfahren nach einem der Ansprüche 16 - 22,
**dadurch gekennzeichnet,**
nach dem Aufbringen der Polymerverbindung eine Barriereschicht abgeschieden wird und anschließend ein gerichteter Ätzschritt durchgeführt wird, um die Barriereschicht und überschüssige Polymerverbindung vom Boden der Vertiefung zu entfernen.

25. Verfahren nach Anspruch 24,
**dadurch gekennzeichnet,**
**dass** es sich bei der Barriereschicht um eine Schicht aus Metallen, insbesondere Titan und/oder Tantal, Metallcarbiden, insbesondere Wolframcarbid und/oder Siliciumcarbid, Metallnitriden, insbesondere Wolframnitrid, Titannitrid und/oder Tantalnitrid, und/oder Metallcarbonitride, insbesondere Wolframcarbonitrid handelt.

26. Verfahren zur Integration poröser Materialien mit niedriger Dielektrizitätskonstante als Trennschichten zwischen Metallisierungsebenen in die Halbleiterfertigung, mit den Schritten:
a. Ätzen einer Vertiefung in eine auf einem Substrat befindliche Schicht eines Materials mit niedriger Dielektrizitätskonstante (ILD),
b. Aufbringen einer Polymerverbindung wie in Anspruch 16 definiert, um die Seitenwände der Vertiefungen zu bedecken,
c. Füllen der Vertiefungen mit Metall.

27. Verfahren nach Anspruch 26,
**dadurch gekennzeichnet,**
**dass** das Substrat eine andere Metallisierungslage eines Wafers ist.

28. Verfahren nach Anspruch 26 oder 27,
**dadurch gekennzeichnet,**
**dass** das Substrat eine Kupfermetallisierungsebene ist.

29. Verfahren nach einem der Ansprüche 26 - 28,
**dadurch gekennzeichnet,**
**dass** die Vertiefung mit einem Metall, bevorzugt Kupfer, befüllt wird.

30. Verfahren nach einem der Ansprüche 26 - 29,
**dadurch gekennzeichnet,**
**dass** nach dem Aufbringen der Polymerverbindung gemäß Schritt b. ein Ätzschritt durchgeführt wird, um überschüssige Polymerverbindung aus der Vertiefung zu entfernen.

31. Verfahren nach einem der Ansprüche 26 - 29,
**dadurch gekennzeichnet,**
nach dem Aufbringen der Polymerverbindung gemäß Schritt b. eine Barriereschicht abgeschieden wird und anschließend ein gerichteter Ätzschritt durchgeführt wird, um die Barriereschicht und überschüssige Polymerverbindung vom Boden der Vertiefung zu entfernen.

32. Verfahren nach Anspruch 31,
**dadurch gekennzeichnet,**
**dass** es sich bei der Barriereschicht um eine Schicht aus Tantal und Tantalnitrid handelt.

33. Verfahren zur Verbindung von Metallisierungsebenen bei der Halbleiterfertigung, wobei:
a. auf eine untere Metallisierungsebene eine Schicht eines Materials mit niederiger Dielektrizitätskonstante (ILD) aufgebracht wird,
b. in die ILD nach herkömmlichen Verfahren Vertiefungen geätzt werden,
c. eine Polymerverbindung wie in Anspruch 16 definiert aufgebracht wird, um die Seitenwände der Vertiefungen zu bedecken und oberflächenexponierte Poren zu versiegeln,
d. die Vertiefungen mit einem Metall befüllt werden, um eine Verbindung zu der unteren Metallisierungsebene herzustellen.

34. Verfahren nach Anspruch 33,
**dadurch gekennzeichnet,**
**dass** es sich bei den Metallisierungsebenen um Kupfermetallisierungen handelt.

35. Verfahren nach Anspruch 33 oder 34,
**dadurch gekennzeichnet,**
**dass** die Vertiefungen mit Kupfer befüllt werden.

36. Verwendung der Polymerverbindungen wie in Anspruch 16 definiert zum Versiegeln oberflächenexponierter Poren poröser Schichten eines Materials mit niedriger Dielektrizitätskonstante (ILD) bei der Chipherstellung.

## Claims

1. Polymer compounds having a polymer main chain and functional groups A and B,
in which the functional group A can be bonded to silicon-containing materials and/or metal nitrides and has the following structure:
(R²-O-)₃₋ₙSiR¹ₙ-R³,
wherein n = 1 or 2,
R¹ and R² are in each case an alkyl or aryl group, it being possible for R¹ and R² to be identical or different, and
R³ is an alkylene or arylene group;
and the functional group B can be bonded to copper metal and/or tantalum, metal oxides, copper(I) oxide and/or copper(II) oxide and has one or more of the following structures: 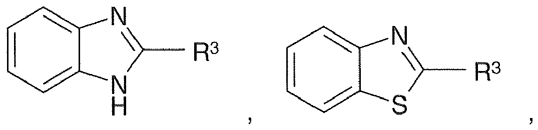 and/or 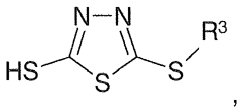 wherein R³ is as defined in group A,
and groups A and B are each linked to the polymer main chain via R³.

2. Polymer compounds as claimed in claim 1, **characterized in that** the monomers of the polymer main chain are ethylene, propylene, styrene, (meth)acrylates, acids, preferably adipic acid, (iso)terephthalic acid, alcohols, preferably butanediol, ethanediol or ethylene glycol, amines, preferably ethanediamine, hexanediamine, amino acids like aminocaprylic acid, ε-caprolactam, ethers, preferably propylene oxide or ethylene oxide, epoxides, preferably epichlorohydrin and/or the polymer main chains are silicones whose monomer units are preferably dimethyldichlorosilane and/or diphenyldichlorosilane.

3. Polymer compounds as claimed in one or more of the preceding claims, **characterized in that** R¹ and/or R² in group A are straight-chain or branched C₁-C₆ alkyls, preferably methyl or ethyl.

4. Polymer compounds as claimed in one or more of the preceding claims, **characterized in that** R¹ and/or R² in group A is a substituted or unsubstituted phenyl, biphenyl and/or naphthyl.

5. Polymer compounds as claimed in claim 4, **characterized in that** the substituent is a C₁-C₁₈ alkyl radical, preferably a C₁-C₆ alkyl radical.

6. Polymer compounds as claimed in one or more of the preceding claims, **characterized in that** R¹ and/or R² in group A is a phenyl radical.

7. Polymer compounds as claimed in one or more of the preceding claims, **characterized in that** R³ in group A is a C₁-C₁₈ alkylene radical, preferably a C₁-C₆ alkylene radical, and/or a C₄-C₈ cycloalkylene radical, preferably a C₅-C₆ cycloalkylene radical.

8. Polymer compounds as claimed in one or more of the preceding claims, **characterized in that** R³ in group B is a C₁-C₁₈ alkylene radical, preferably a C₁-C₆ alkylene radical, and/or a C₄-C₈ cycloalkylene radical, preferably a C₅-C₆ cycloalkylene radical.

9. Polymer compounds as claimed in one or more of the preceding claims, **characterized in that** R³ in group A and/or B, independently of one another, is a substituted or unsubstituted phenylene, biphenylene and/or naphthylene, and if it is substituted the substituent is preferably a C₁-C₁₈ alkyl radical, more preferably a C₁-C₆ alkyl radical.

10. Polymer compounds as claimed in one or more of the preceding claims, **characterized in that** R₃ in group A and/or B, independently of one another, is a phenylene radical.

11. Polymer compounds as claimed in one or more of the preceding claims, **characterized in that** R¹ in group A is a straight-chain or branched C₁-C₆ alkyl radical, preferably methyl or ethyl.

12. Polymer compounds as claimed in one or more of the preceding claims, **characterized in that** the polymers have a molecular weight of from 10 000 Da to 10 000 000 Da, preferably 20 000 - 1 000 000 Da.

13. Polymer compounds as claimed in one or more of the preceding claims, **characterized in that** the polymer compounds are linear.

14. A composition containing polymer compounds as claimed in one or more of the preceding claims and one or more solvents.

15. The composition as claimed in claim 14, **characterized in that** alkanes, preferably C₅-C₁₀ isoalkanes, such as hexane and/or heptane, cycloalkanes, preferably cyclopentane and/or cyclohexane, ethers, preferably C₂-C₈ dialkyl ethers and/or tetrahydrofuran, and/or ketones, in particular C₁-C₈ dialkyl ketones, preferably methyl ethyl ketone, are used as solvents.

16. A method for sealing surface-exposed pores of porous materials with a low dielectric constant used in semiconductor fabrication as separating layers between metallization levels, in which one or more of the following polymer compounds:
polymer compounds having a polymer main chain and functional groups A and B,
in which the functional group A can be bonded to silicon-containing materials and/or metal nitrides and has the following structure:
(R²-O-)₃₋ₙSiR¹ₙ-R³,
wherein n=1 or 2,
R¹ and R² are in each case an alkyl or aryl group, it being possible for R¹ and R² to be identical or different,
and R³ is an alkylene or arylene group;
and the functional group B can be bonded to copper metal and/or tantalum, metal oxides, copper(I) oxide and/or copper(II) oxide and has one or more of the following structures: 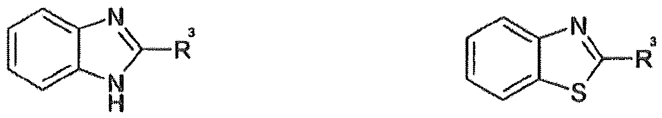 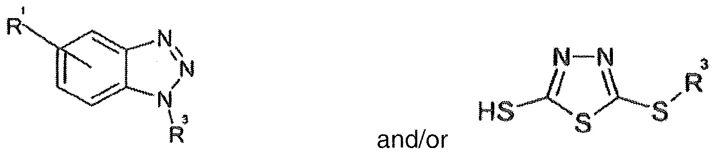
wherein R¹ and R³ are as defined in group A,
and groups A and B are each linked to the polymer main chain via R³,
are applied to the porous material with a low dielectric constant.

17. The method as claimed in claim 16, **characterized in that** the interlayer dielectrics are silicon-containing materials, such as carbon-doped silicon dioxide, silsesquioxanes, such as hydrogen silsesquioxane (HSQ) or methyl silsesquioxane (MSQ).

18. The method as claimed in claim 16 or 17, **characterized in that** the layer thickness of the polymer compound layer applied corresponds to a monolayer.

19. The method as claimed in any one of claims 16 - 18, **characterized in that** the thickness of the polymer compound layer applied is 0.5 - 10 nm, preferably 1 - 5 nm.

20. The method as claimed in any one of claims 16 - 19, **characterized in that** the polymer compound is applied by a spin-on method or by dip coating.

21. The method as claimed in any one of claims 16 - 20, **characterized in that** after the application step a heating step is carried out in order to dry the applied layer and/or to remove solvents and volatile constituents.

22. The method as claimed in any one of claims 16 - 21, **characterized in that** the polymer compounds are applied to the inner walls of a recess etched into an interlayer dielectric (ILD) during chip production.

23. The method as claimed in any one of claims 16 - 22, **characterized in that** an etching step is carried out after the polymer compound has been applied, in order to remove excess polymer compound from the recess.

24. The method as claimed in any one of claims 16 - 22, **characterized in that** after the polymer compound has been applied a barrier layer is deposited, and then a targeted etching step is carried out in order to remove the barrier layer and excess polymer compound from the base of the recess.

25. The method as claimed in claim 24, **characterized in that** the barrier layer is a layer of metals, in particular titanium and/or tantalum, metal carbides, in particular tungsten carbide and/or silicon carbide, metal nitrides, in particular tungsten nitride, titanium nitride and/or tantalum nitride, and/or metal carbonitrides, in particular tungsten carbonitride.

26. A method for the integration of porous materials with a low dielectric constant as separating layers between metallization levels in semiconductor fabrication, comprising
a. etching a recess into a layer of a material with a low dielectric constant (ILD) which is located on a substrate;
b. applying a polymer compound as defined in claim 16 in order to cover the side walls of the recesses; and
c. filling the recesses with metal.

27. The method as claimed in claim 26, **characterized in that** the substrate is another metallization layer of a wafer.

28. The method as claimed in claim 26 or 27, **characterized in that** the substrate is a copper metallization level.

29. The method as claimed in any one of claims 26 - 28, **characterized in that** the recess is filled with a metal, preferably copper.

30. The method as claimed in any one of claims 26 - 29, **characterized in that** after the polymer compound has been applied in accordance with step b., an etching step is carried out in order to remove excess polymer compound from the recess.

31. The method as claimed in any one of claims 26 - 29, **characterized in that** after the polymer compound has been applied in accordance with step b., a barrier layer is deposited and then a targeted etching step is carried out in order to remove the barrier layer and excess polymer compound from the base of the recess.

32. The method as claimed in claim 31, **characterized in that** the barrier layer is a layer of tantalum and tantalum nitride.

33. A method for connecting metallization levels in semiconductor fabrication, wherein:
a. a layer of a material with a low dielectric constant (ILD) is applied to a lower metallization level;
b. recesses are etched into the ILD using conventional methods;
c. a polymer compound as defined in claim 16 is applied in order to cover the side walls of the recesses and to seal surface-exposed pores; and
d. the recesses are filled with a metal in order to produce a connection to the lower metallization level.

34. The method as claimed in claim 33, **characterized in that** the metallization levels are copper metallizations.

35. The method as claimed in claim 33 or 34, **characterized in that** the recesses are filled with copper.

36. Use of the polymer compounds as defined in claim 16 to seal surface-exposed pores in porous layers of a material with a low dielectric constant (ILD) during chip production.

## Revendications

1. Composés polymères avec une chaîne principale polymère et des groupes fonctionnels A et B,
le groupe fonctionnel A pouvant se lier à des matériaux renfermant du silicium et/ou à des nitrures métalliques et présentant la structure suivante :
(R²-O-)₃₋ₙSiR¹ₙ-R³,
dans laquelle n=1 ou 2,
R¹ et R² sont respectivement un groupe alkyle ou aryle, R¹ et R² pouvant être identiques ou différents,
et R³ est un groupe alkylène ou arylène ;
et le groupe fonctionnel B peut se lier à du cuivre métallique et/ou à du tantale, à un oxyde cuivreux et/ou à un oxyde cuivrique, et présente une ou plusieurs des structures suivantes : 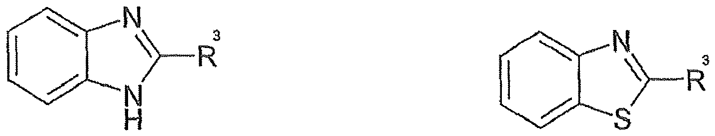 et/ou 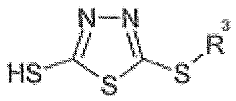 dans laquelle R³ a la même définition que dans le groupe A,
et les groupes A et B sont liés chacun à une chaîne principale polymère par l'intermédiaire de R³.

2. Composés polymères selon la revendication 1, **caractérisés par le fait que** les monomères de la chaîne principale polymère sont de l'éthylène, du propylène, du styrène, du (méth)acrylate, des acides, préférentiellement de l'acide adipique, de l'acide (iso)téréphtalique, des alcools, préférentiellement du butanediol, de l'éthanediol ou de l'éthylène glycol, des amines, préférentiellement de l'éthanediamine, de l'hexanediamine, des acides aminés comme l'acide caprylique, du ε-caprolactame, de l'éther, préférentiellement de l'oxyde d'éthylène et de l'oxyde de propylène, de l'époxyde, préférentiellement de l'épichlorhydrine et/ou que les chaînes principales polymères sont des silicones, dont les unités monomères sont préférentiellement du diméthyldichlorosilane et/ou du diphényldichlorosilane.

3. Composés polymères selon l'une ou plusieurs des revendications précédentes, **caractérisés par le fait que** R¹ et/ou R² sont des alkyles C₁ à C₆ linéaires ou ramifiés dans le groupe A, préférentiellement du méthyle ou de l'éthyle.

4. Composés polymères selon l'une ou plusieurs des revendications précédentes, **caractérisés par le fait que** R¹ et/ou R² est dans le groupe A un phényle substitué ou non substitué, du biphényle et/ou du naphthyle.

5. Composés polymères selon la revendication 4, **caractérisés par le fait que** le substituant est un radical alkyle C₁ à C₁₈, préférentiellement un radical alkyle C₁ à C₆.

6. Composés polymères selon l'une ou plusieurs des revendications précédentes, **caractérisés par le fait que** R¹ et/ou R² est dans le groupe A un radical phényle.

7. Composés polymères selon l'une ou plusieurs des revendications précédentes, **caractérisés par le fait que** R³ est dans le groupe A un radical alkylène C₁ à C₁₈, préférentiellement un radical alkylène C₁ à C₆, et/ou un radical cycloalkylène C₄ à C₈, préférentiellement un radical cycloalkylène C₅ à C₆.

8. Composés polymères selon l'une ou plusieurs des revendications précédentes, **caractérisés par le fait que** R³ est dans le groupe B un radical alkylène C₁ à C₁₈, préférentiellement un radical alkylène C₁ à C₆, et/ou un radical cycloalkylène C₄ à C₈, préférentiellement un radical cycloalkylène C₅ à C₆.

9. Composés polymères selon l'une ou plusieurs des revendications précédentes, **caractérisés par le fait que** R³ est dans le groupe A et/ou B indépendamment l'un de l'autre un phénylène substitué ou non substitué, un biphénylène et/ou un naphthylène, le substituant étant préférentiellement, en cas de substitution, un radical alkyle C₁ à C₁₈, encore plus préférentiellement un radical alkyle C₁ à C₆.

10. Composés polymères selon l'une ou plusieurs des revendications précédentes, **caractérisés par le fait que** R³ est un radical phénylène dans le groupe A et/ou B indépendamment l'un de l'autre.

11. Composés polymères selon l'une ou plusieurs des revendications précédentes, **caractérisés par le fait que** R¹ est dans le groupe A un radical alkyle linéaire ou ramifié C₁ à C₆, préférentiellement du méthyle ou de l'éthyle.

12. Composés polymères selon l'une ou plusieurs des revendications précédentes, **caractérisés par le fait que** les polymères présentent un poids moléculaire de 10 000 Da à 10 000 000 Da, préférentiellement de 20 000 à 1 000 000 Da.

13. Composés polymères selon l'une ou plusieurs des revendications précédentes, **caractérisés par le fait que** les composés polymères sont linéaires.

14. Composition, comprenant des composés polymères selon l'une ou plusieurs des revendications précédentes, ainsi qu'un ou plusieurs solvants.

15. Composition selon la revendication 14, **caractérisée par le fait que** l'alcane, préférentiellement l'isoalcane C₅ à C₁₀ ainsi que l'hexane et/ou l'heptane, le cycloalcane, préférentiellement le cyclopentane et/ou le cyclohexane, l'éther, préférentiellement le dyalkyléther C₂ à C₈ et/ou le tétrahydrofurane, et/ou le cétone, en particulier le dialkylcétone C₁ à C₈, préférentiellement le méthylethylcétone, sont utilisés comme solvant.

16. Procédé de scellement de pores, dont la surface est exposée, de matériaux poreux utilisés lors de la fabrication de semi-conducteurs en tant que couches de séparation entre des plans de métallisation avec une faible constante diélectrique, dans lequel un ou plusieurs des composés polymères suivants sont appliqués sur le matériau poreux avec une faible constante diélectrique :
composés polymères avec une chaîne principale polymère et des groupes fonctionnels A et B, le groupe fonctionnel A pouvant se lier à des matériaux renfermant du silicium et/ou à des nitrures métalliques et présentant la structure suivante :
(R²-O-)₃₋ₙSiR¹ₙ-R³,
dans laquelle n=1 ou 2,
R¹ et R² sont respectivement un groupe alkyle ou aryle, R¹ et R² pouvant être identiques ou différents,
et R³ est un groupe alkylène ou arylène ;
et le groupe fonctionnel B peut se lier à du cuivre métallique et/ou à du tantale, à un oxyde cuivreux et/ou à un oxyde cuivrique, et présente une ou plusieurs des structures suivantes : 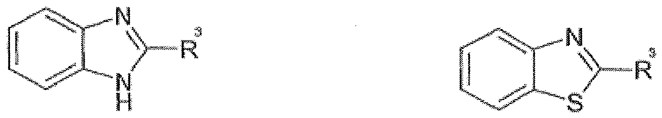 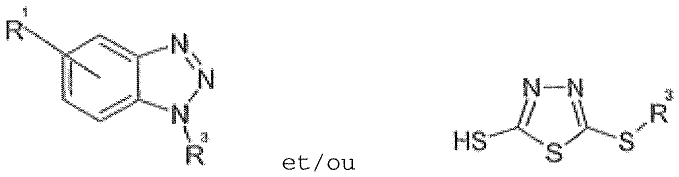
dans laquelle R¹ et R³ ont la même définition que dans le groupe A,
et les groupes A et B sont liés chacun à une chaîne principale polymère par l'intermédiaire de R³.

17. Procédé selon la revendication 16, **caractérisé par le fait qu'**il s'agit pour les couches interdiélectriques de matériaux renfermant du silicium comme le dioxyde de silicium dopé au carbone, le silsesquioxane comme l'hydrogénosilsesquioxane (HSQ) ou le méthylsilsesquioxane (MSQ).

18. Procédé selon la revendication 16 ou 17, **caractérisé par le fait que** l'épaisseur de couche de la couche de composé polymère appliquée correspond à une monocouche.

19. Procédé selon l'une des revendications 16 à 18, **caractérisé par le fait que** l'épaisseur de la couche de composé polymère appliquée est de 0,5 à 10 nm, préférentiellement de 1 à 5 nm.

20. Procédé selon l'une des revendications 16 à 19, **caractérisé par le fait que** le composé polymère est appliqué selon le procédé de dépôt par rotation ou par immersion.

21. Procédé selon l'une des revendications 16 à 20, **caractérisé par le fait qu'**une phase de chauffage est effectuée après l'application pour sécher la couche appliquée et/ou pour retirer les solvants et les composants volatils.

22. Procédé selon l'une des revendications 16 à 21, **caractérisé par le fait que** les composés polymères sont amenés sur les parois intérieures d'un renfoncement gravé dans un diélectrique intercouche (ILD) lors de la production de puces.

23. Procédé selon l'une des revendications 16 à 22, **caractérisé par le fait qu'**une gravure est effectuée après l'application du composé polymère pour retirer le composé polymère du renfoncement.

24. Procédé selon l'une des revendications 16 à 22, **caractérisé par le fait qu'**une couche barrière est déposée après l'application du composé polymère, puis une étape de gravure dirigée est effectuée pour retirer la couche barrière et le composé polymère de la base du renfoncement.

25. Procédé selon la revendication 24, **caractérisé par le fait qu'**il s'agit pour la couche barrière d'une couche constituée de métaux, en particulier de titane et/ou de tantale, de carbures métalliques, en particulier de carbure de tungstène et/ou de carbure de silicium, de nitrures métalliques, en particulier de nitrure de tungstène, de nitrure de titane et/ou de nitrure de tantale, et/ou de carbonitrures métalliques, en particulier de carbonitrure de tungstène.

26. Procédé d'intégration de matériaux poreux ayant une faible constante diélectrique en tant que couches de séparation entre des plans de métallisation lors de la fabrication de semi-conducteurs, avec les étapes de :
a. gravure d'un renfoncement dans une couche se trouvant sur un substrat d'un matériau ayant une faible constante diélectrique (ILD),
b. application d'un composé polymère comme défini à la revendication 16 pour recouvrir les parois latérales des renfoncements,
c. remplissage des renfoncements avec du métal.

27. Procédé selon la revendication 26, **caractérisé par le fait que** le substrat est une autre couche de métallisation d'une tranche.

28. Procédé selon la revendication 26 ou 27, **caractérisé par le fait que** le substrat est un plan de métallisation en cuivre.

29. Procédé selon l'une des revendications 26 à 28, **caractérisé par le fait que** le renfoncement est rempli d'un métal, préférentiellement de cuivre.

30. Procédé selon l'une des revendications 26 à 29, **caractérisé par le fait qu'**une gravure est effectuée après l'application du composé polymère selon l'étape b. pour retirer le composé polymère du renfoncement.

31. Procédé selon l'une des revendications 26 à 29, **caractérisé par le fait qu'**une couche barrière est déposée après l'application du composé polymère selon l'étape b., puis une étape de gravure dirigée est effectuée pour retirer la couche barrière et le composé polymère de la base du renfoncement.

32. Procédé selon la revendication 31, **caractérisé par le fait qu'**il s'agit pour la couche barrière d'une couche de tantale ou de nitrure de tantale.

33. Procédé de liaison de plans de métallisation lors de la fabrication de semi-conducteurs, dans lequel :
a. une couche de matériau ayant une faible constante diélectrique (ILD) est appliquée sur un plan de métallisation inférieur,
b. des renfoncements sont gravés dans les ILD selon un procédé traditionnel,
c. un composé polymère est appliqué comme défini à la revendication 16 pour recouvrir les parois latérales des renfoncement et pour sceller les pores dont la surface est exposée,
d. les renfoncements sont remplis d'un métal pour réaliser une liaison avec le plan de métallisation.

34. Procédé selon la revendication 33, **caractérisé par le fait qu'**il s'agit pour les plans de métallisation de métallisations en cuivre.

35. Procédé selon la revendication 33 ou 34, **caractérisé par le fait que** les renfoncements sont remplis de cuivre.

36. Utilisation desdits composés polymères comme défini à la revendication 16 pour sceller des pores de matériaux poreux, dont la surface desdits pores est exposée, avec une faible constante diélectrique (ILD) lors de la production de puces.
